# EUROPEAN PATENT APPLICATION

(11) **EP 2 333 956 A1**
(43) Date of publication of application: **15.06.2011**
(21) Application number: 10194066.6
(22) Date of filing: 07.12.2010
(51) Int. Cl.: H03K 17/041, H02K 5/22, H02M 7/48

(54) **Semiconductor switch relay module for a power distribution system**

(30) Priority: 07.12.2009 US 632065
(71) Applicant: Hamilton Sundstrand Corporation, Windsor Locks, CT 06096-1010 (US)
(72) Inventor: Schnetker, Ted R., Rockford, IL 61107 (US); Sytsma, Steven J., Waukegan, IL 60085 (US)
(74) Representative: Tomlinson, Kerry John

(57) **Abstract**

A power distribution system (100) has a bus bar (130) and a gallium nitride based semiconductor switch (140) interrupting the bus bar. A controller (150) is electrically coupled to, and controlling, the semiconductor switch.

## Description

### BACKGROUND OF THE INVENTION

This disclosure relates generally to solid state power switching and more specifically to power distribution systems using solid state switches.

Power distribution systems, such as those used in vehicles with on-board power generation, utilize relay modules to control the distribution of electrical power throughout the system. The relay modules are connected to the bus bars and include multiple redundant mechanical contactors, which can close to allow power flow through the bus bars or open to prevent power flow. The mechanical contactors produce large amounts of heat energy that distributes into the bus bars. The bus bars reject the heat energy into the surrounding atmosphere. The multiple redundant contactors allow for continued operation of the relay module if any of the contactors should fail.

### SUMMARY OF THE INVENTION

Disclosed is a power distribution system, which utilizes bus bars and semiconductor switches to distribute electrical power. At least one gallium nitride based semiconductor switch is connected to the bus bars and interrupts the bus bars such that when the semiconductor switch is closed, power is allowed to flow through the bus bar and when the semiconductor switch is open, power flow through the bus bars is prevented. The semiconductor's on/off state is controlled by a controller, which is communicatively coupled to the semiconductor switch.

Also disclosed is a replaceable relay module for a power distribution system. The relay module has a bus bar and a gallium nitride based semiconductor switch connected to and interrupting the bus bar, such that when the gallium nitride based semiconductor switch is closed, power is allowed to flow through the bus bar, and when the gallium nitride based semiconductor switch is open, power is prevented from flowing through the bus bar. The relay module also has a set of connectors, which are capable of connecting the relay module to a power distribution system.

These and other features of the present invention can be best understood from the following specification and drawings, the following of which is a brief description.

### BRIEF DESCRIPTION OF THE DRAWINGS

Figure 1 illustrates a generic aircraft, which has an on-board power distribution system.
Figure 2 illustrates a block diagram of an example power distribution panel.

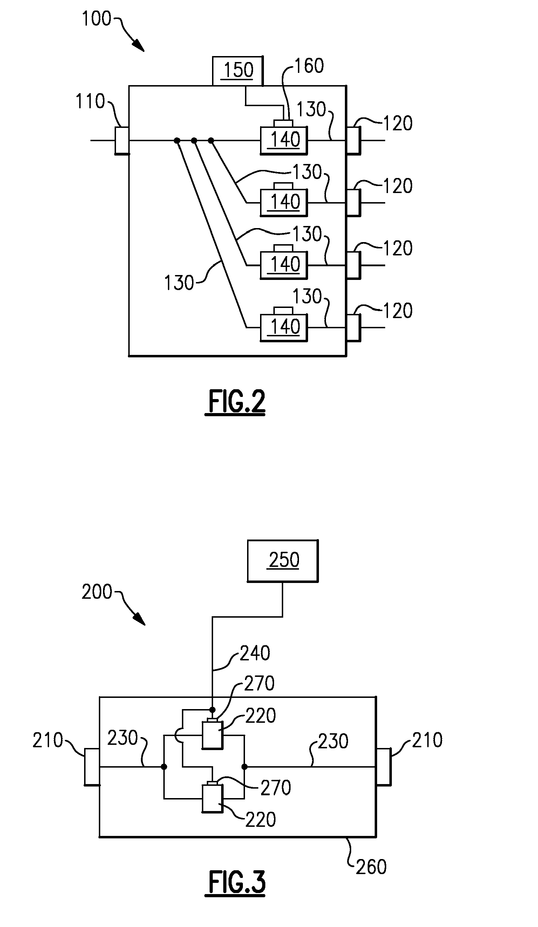

Figure 2 illustrates a block diagram of an example replaceable relay module.

### DETAILED DESCRIPTION OF THE PREFERRED EMBODIMENT

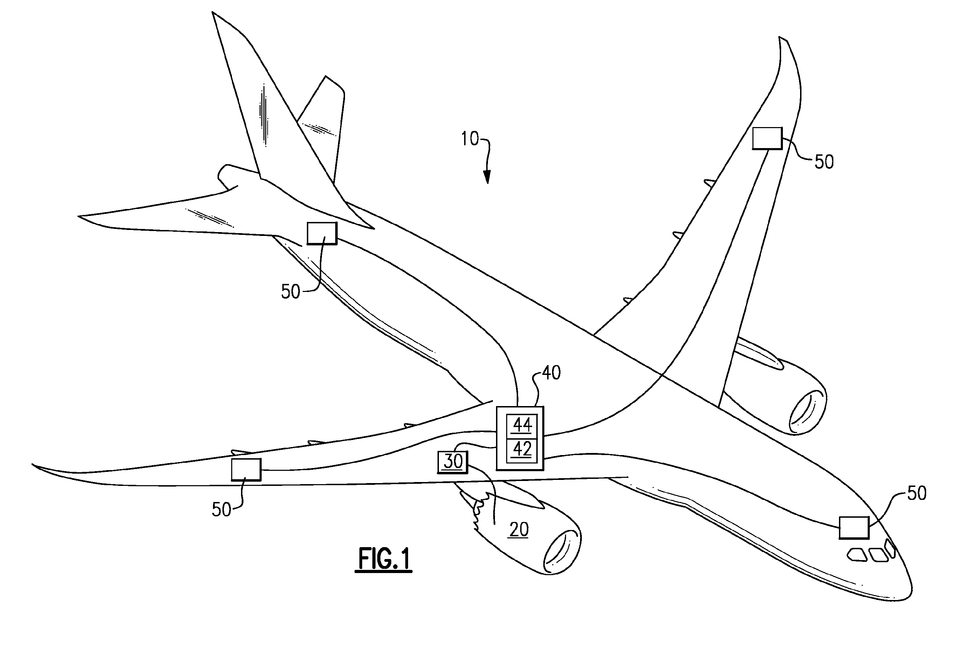

Figure 1 illustrates an aircraft 10, which utilizes rotation in its engines 20 to generate electrical power in a generator 30. The generator 30 is connected to a power distribution panel 40, which has relay modules 42 and a controller 44. Multiple on-board electronic systems 50 are connected to the power distribution panel 40. Although not illustrated in Figure 1, multiple power distribution panels 40 or relay modules 42 can be used at the electronic systems 50 throughout the aircraft 10 in order to achieve finer control of electrical power distribution. It is to be understood that the power distribution panel 40 may alternatively be used in other types of vehicles and is not limited to aircraft.

Figure 2 schematically illustrates a power distribution panel 100, which may be used as the power distribution panel 40 in the system illustrated in Figure 1. The panel 100 includes a power input 110, which connects multiple bus bars 130 to an input power source (not shown). The relay switches 140 interrupt the bus bars 130. The bus bars 130 are connected to power outputs 120. Each of the power outputs 120 can be connected to an on-board electrical system 50 (illustrated in Figure 1) and selectively provide power to that electrical system 50. Each of the relay switches 140 is controlled by a controller 150, which is communicatively coupled to a control input of each of the relay modules 140.

Typically, mechanical contactors are used to physically close and open the relay switch 140 in currently known systems. However, the relay switches 140 of the present disclosure are solid state devices that do not require mechanical contactors. For instance, the relay switches 140 are semiconductor transistors or circuits using multiple semiconductor transistors to perform a switching action. When power is required at a desired electrical system, the controller 150 sends a control signal to the corresponding relay switch 140, indicating that the relay switch 140 should be closed. Once closed, a completed electrical path is formed, and electrical power can flow from a power input, through the bus bar 130 to the output 120, and to the corresponding electrical system 50. Alternately, if supplying power to the corresponding electrical system 50 is not desired, no signal is supplied to the relay switch 140, and the relay switch 140 remains open if it is in the open state, or switches to open if it is in the closed state.

The relay switches 140, illustrated in Figure 2, utilize semiconductor switches, such as transistors, to electrically open and close the bus bar 130 circuits without requiring any moving parts. The relay switches 140 in the present example are mounted to the bus bar 130, rather than being mounted to a panel box, which facilitates reducing size and weight. The relay switches 140 are additionally thermally connected to the bus bars 130 and diffuse heat energy generated as a result of the switching operation into the bus bars 130. The bus bars 130 then diffuse the heat energy into the atmosphere. Thus, the bus bars 130 act as a heat sink for the relay switch 140.

During operation, the bus bars 130 can reach high temperatures due to the heat energy generated by the relay switch 140. Consequently, the relay switches 140 mounted to the bus bars 130 are selected to have a high heat tolerance. One type of semiconductor relay switch 140 which is suitable is a switch having a gallium nitride semiconductor material. Gallium nitride based semiconductor switches have higher temperature tolerances than their silicon counterparts, and are therefore capable of effectively operating in high temperature environments. Gallium nitride based semiconductor switches also provide an additional benefit of allowing current on the connected bus bar 130 to travel in a positive and a negative direction, thereby allowing a single gallium nitride semiconductor switch to control an alternating current (AC) bus bar, where a relay module employing uni-direction semiconductor switches (such as silicon based semiconductor switches) would require a more complex switch network to control an AC bus bar, such as the illustrated bus bar 130. This effect further allows the weight and size of the power distribution system to be minimized.

Each of the relay switches 140 can also include a sensor 160, which can detect the operational status of each semiconductor, whether the relay switch 140 has failed, the temperature of the relay switch 140, and voltage and current levels across the relay switch 140. The sensor 160 can then report this data to the controller 150, and a notification indicating when the relay switch 140 has failed can be provided to a user. This functionality allows a technician or other mechanic to quickly identify and replace a failed relay switch 140. Furthermore, semiconductor switches, such as gallium nitride based semiconductor switches, have a semi-regular life span and consequently will typically fail within a predictable time frame, thereby allowing for scheduled, rather than emergency, maintenance. The sensor 160 can also detect other characteristics of the semiconductor switches, and thereby provide further functionality.

One method of facilitating the operational status monitoring of the relay switch 140 via the sensor 160 inserts a signal at an input of the relay switch 140, and detects if the signal is present on the output of the relay switch 140. In such a configuration, the detection signal is removed after detection at the output using a simple filter, or using any other known technique.

The sensor 160 can further detect the health of the relay switch 140 by measuring the voltage, current, or temperature characteristics of the relay switch 140 over time during the operation of the relay switch 140. The controller 150 can then compare the measured values to pre-programmed values stored in its memory and determine the health of the relay switch 140 via this comparison. Alternately, the sensor 160 can have a local memory unit and the comparison values described above can be stored locally on the sensor 160 rather than the controller 150. This comparison allows the sensor 160 to output a single "health" signal to the controller 150.

The sensor 160 outputs can also be used to provide an overcurrent protection, by providing trip values which trip the switch when a sensed value, such as current or voltage, is exceeded, or lightning protection by disabling the relay switch 140 when a lightning strike is detected. The above described uses for the sensor 160 are non-exclusive, and further uses additionally fall within the scope of this application.

In addition to the power distribution panel 100 illustrated in Figure 2, a system may also utilize relay modules 200 downstream of the power distribution panel 100 or even within the power distribution panel 100 to provide finer control over the power distribution. Known relay modules 200 use one or more mechanical contactors to control power flow on a bus bar in much the same way as the known relay switches of the power distribution panels described above.

Figure 3 illustrates a replaceable relay module 200. The relay module 200 includes a set of connectors 210, which can be connected to a bus bar, such as the bus bar 130 illustrated in Figure 2. The relay module 200 includes a bus bar 230 that is connected to the set of connectors 210, within a housing 260. Interrupting the bus bar 230 is a pair of semiconductor switches 220, which are mounted on the bus bar 230. The semiconductor switches can be mounted directly onto the bus bar 230, or an interposer layer may be connected to the bus bar 230 and the semiconductor switches can be mounted to the interposer layer.

Each of the semiconductor switches 220 is connected to a controller 250 via a control line 240. Each of the semiconductor switches 220 can also include a built in sensor 270. The sensor 270 detects the operational state of the switch 220 and switch functionality, and may operate in a manner similar to that of the sensor 160 described with regard to Figure 2. While the example of Figure 3 illustrates two semiconductor switches 220, any configuration of switches 220, which produces the same effect, could be used.

As described above in regards to Figure 1, the bus bar 230 operates as a heat sink relative to the semiconductor switch 220. The heat sinking can result in a high operating temperature and consequently, the semiconductor material used for the switch 220 should have a high heat tolerance. As described above, the relay module 200 uses gallium nitride based semiconductor switches 220. The switches 220 are arranged redundantly thereby allowing the relay module 200 to continue to function if one of the switches 220 fails. The connected controller 250 can be a remote controller, which is communicatively coupled to the switches 220 as is illustrated, or can be a local controller directly mounted on or in the housing 260. The controller is also capable of receiving signals from the sensor 270, which can be built into the semiconductor switches 220 or connected to the semiconductor switches 220. The sensor 270 can then detect the operational status of each of the switches 220 as well as detecting and collecting other data.

Since the semiconductor switches 220 are physically smaller than mechanical relays, the replaceable relay module 200 of Figure 3 can be constructed in a manner allowing the relay modules 200 to replace mechanical relay modules, which are currently installed in a vehicle, while weighing less than current replacement modules and thereby provide a reduced weight. The modifications to the relay module housing 260 and the connectors 210 necessary to incorporate the described relay modules 200 into a current system fall within the ordinary skill in the art and fall within the present disclosure.

Although multiple embodiments of this invention have been disclosed, a worker of ordinary skill in this art would recognize that certain modifications would come within the scope of this invention. For that reason, the following claims should be studied to determine the true scope and content of this invention.

## Claims

1. A power distribution apparatus comprising;
a bus bar;
at least one gallium nitride based semiconductor switch connected to said bus bar and switchable between a closed state in which electrical power can flow through said bus bar and an open state in which electrical power is prevented from flowing through said bus bar; and
connections for a controller to be electrically and communicatively coupled to said at least one gallium nitride based semiconductor switch such that said controller is capable of controlling an open/closed state of said gallium nitride based semiconductor switch.

2. The power distribution apparatus of claim 1, wherein said gallium nitride based semiconductor switch is mounted on said bus bar using an interposer layer.

3. The power distribution apparatus of claim 1 or 2, wherein said gallium nitride based semiconductor switch is a bi-directional transistor.

4. The power distribution apparatus of claim 3, wherein said bus bar comprises an alternating current bus bar.

5. The power distribution apparatus of any preceding claim, further comprising at least a second gallium nitride based semiconductor switch, wherein said at least one second gallium nitride based semiconductor switch is redundantly arranged relative to said at least one gallium nitride based semiconductor switch.

6. The power distribution apparatus of any preceding claim, further comprising an electrical communication line communicatively coupling said at least one gallium nitride based semiconductor switch on a first end to a data input of a controller on a second end.

7. The power distribution apparatus of claim 6, further comprising a sensor capable of sensing an operational status of said at least one gallium nitride based semiconductor switch and capable of communicating said status on said electrical communication line.

8. The a power distribution apparatus of claim 7, wherein said sensor is additionally capable of detecting at least one of a voltage, current, or temperature of said at least one gallium nitride based semiconductor switch.

9. The power distribution apparatus of claim 8, wherein said sensor further comprises a local memory unit, and said local memory unit stores at least one voltage, current, or temperature comparison value.

10. A power distribution system comprising:
at least one power distribution apparatus as recited in any preceding claim; and
a controller electrically and communicatively coupled to said at least one gallium nitride based semiconductor switch such that said controller is capable of controlling an open/closed state of said gallium nitride based semiconductor switch.

11. The power distribution system of claim 10, wherein said at least one gallium nitride based semiconductor switch comprises a plurality of gallium nitride based semiconductor switches in an electrically redundant arrangement such that when one gallium nitride based semiconductor switch within said plurality of switches is operational, the plurality of switches remains functional.

12. The power distribution system of claim 10 or 11, further comprising at least one sensor coupled to said at least one gallium nitride based semiconductor switch, wherein said sensor is capable of detecting a functionality of said gallium nitride based semiconductor switch and reporting said functionality to said controller.

13. The power distribution system of claim 10, 11 or 12, wherein said at least one gallium nitride based semiconductor switch is mounted on said bus bar in thermal communication with said bus bar.

14. The power distribution system of claim 10, 11, 12 or 13 wherein said at least one gallium nitride based semiconductor switch is contained within a replaceable relay module.

15. A replaceable relay module for a power distribution system comprising:
a housing;
an apparatus as claimed in any of claims 1 to 9; and
a set of connectors mounted on said housing and connected to said bus bar and electrically connecting said replaceable relay module to a power distribution system.
